# EUROPEAN PATENT APPLICATION

(11) **EP 4 203 065 A1**
(43) Date of publication of application: **28.06.2023**
(21) Application number: 22208239.8
(22) Date of filing: 18.11.2022
(51) Int. Cl.: H01L 29/45, H01L 21/285, H01L 23/52, H01L 29/417, H01L 29/78, H01L 29/786, H01L 29/24

(54) **INTEGRATED CIRCUITS WITH MAX OR MX CONDUCTIVE MATERIALS**

(30) Priority: 21.12.2021 US 202117557128
(71) Applicant: INTEL Corporation, Santa Clara, CA 95054 (US)
(72) Inventor: CHEBIAM, Ramanan, Hillsboro, 97124 (US); METZ, Matthew, Portland, 97229 (US); KOBRINSKY, Mauro, Portland, 97229 (US); JEZEWSKI, Christopher, Portland, 97229 (US); AVCI, Uygar, Portland, 97225 (US); BIELEFELD, Jeffery, Forest Grove, 97116 (US); O'BRIEN, Kevin, Portland, 97209 (US); CLENDENNING, Scott, Portland, 97225 (US); PENUMATCHA, Ashish Verma, Beaverton, 97003 (US); NAYLOR, Carl, Portland, 97229 (US); CHEN, Jiun-Ruey, Hillsboro, 97124 (US); MAXEY, Kirby, Hillsboro, 97123 (US); DOROW, Chelsey, Portland, 97209 (US); LEE, Sudurat, Hillsboro, 97124 (US)
(74) Representative: HGF

(57) **Abstract**

Described herein are integrated circuit devices with conductive regions formed from MX or MAX materials. MAX materials are layered, hexagonal carbides and nitrides that include an early transition metal (M) and an A group element (A). MX materials remove the A group element. MAX and MX materials are highly conductive, and their two-dimensional layer structure allows very thin layers to be formed. MAX or MX materials can be used to form several conductive elements of IC circuits, including contacts, interconnects, or liners or barrier regions for contacts or interconnects.

## Description

### Technical Field

This disclosure relates generally to the field of integrated circuit (IC) structures and devices, and more specifically, to conductive materials incorporated in such IC structures and devices.

### Background

In IC devices, electrically conductive materials are used to form various parts of electrical circuits. For example, electrically conductive materials are used to form contacts to semiconductor materials within transistors or other devices. In particular, a transistor may have one contact to a source formed in a semiconductor channel, and a second contact to a drain formed in the semiconductor channel. Electrically conductive materials also form interconnects, which provide electrically conductive paths between transistors and other circuit elements. For example, a transistor typically has a source contact, a drain contact, and a gate contact, each of which is coupled to a respective portion of interconnect that delivers electrical signal from or to another portion of the IC device. Copper and other metals are typically used as electrical conductors in circuits. Scaling existing material to smaller sizes while maintaining high-reliability conductive pathways is a challenge.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-section showing a general structure of a layered MAX material, according to some embodiments of the present disclosure.
FIG. 2 is a cross-section showing a general structure of a layered MX material, according to some embodiments of the present disclosure.
FIG. 3 is a perspective view illustrating an example arrangement of a nanoribbon transistor with a MX or MAX material forming the source and drain contacts, according to some embodiments of the present disclosure.
FIG. 4 is a cross-sectional view showing an example arrangement of transistor with back-side contacts that may include a MX or MAX material, according to some embodiments of the present disclosure.
FIG. 5 is a cross-sectional view showing an example arrangement of transistor with front-side contacts that may include a MX or MAX material, according to some embodiments of the present disclosure.
FIG. 6A and 6B illustrate two example arrangements of source and drain contacts that include a MX or MAX material, according to some embodiments of the present disclosure.
FIGs. 7A-7B are perspective and cross-sectional views, respectively, of an example transistor implemented as a FinFET with source and drain contacts that may include a MX or MAX material, according to some embodiments of the present disclosure.
FIG. 8 is a cross-sectional view of an example transistor with interconnects coupled to the transistor, where the interconnects may include an MX or MAX material, according to some embodiments of the present disclosure.
FIGs. 9A and 9B provide cross-sectional views along the planes AA' and BB', respectively, of the example arrangement shown in FIG. 8, according to some embodiments of the present disclosure.
FIG. 10A and 10B are two example zoomed-in cross-sectional views of interconnect regions that include MX or MAX materials, according to some embodiments of the present disclosure.
FIG. 11 is a flowchart illustrating a method for forming a layered MX or MAX conductive material in an IC device, according to some embodiments of the present disclosure.
FIGS. 12A and 12B are top views of a wafer and dies that include conductive regions formed from MX or MAX materials in accordance with any of the embodiments disclosed herein.
FIG. 13 is a cross-sectional side view of an IC device that may include conductive regions formed from MX or MAX materials in accordance with any of the embodiments disclosed herein.
FIG. 14 is a cross-sectional side view of an IC device assembly that may include conductive regions formed from MX or MAX materials in accordance with any of the embodiments disclosed herein.
FIG. 15 is a block diagram of an example computing device that may include conductive regions formed from MX or MAX materials in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are IC devices that include conductive regions that include MX and/or MAX materials, and methods for producing such devices. An IC device includes various circuit elements, such as transistors and capacitors, coupled together by conductive materials, such as contacts and interconnects. MAX materials, also referred to as MAX phases, are layered, hexagonal carbides and nitrides that have the general formula Mₙ+₁AXₙ, where n=1 to 4, and M is an early transition metal, A is an A group (or main group) element, and X is either carbon or nitrogen. MAX materials exhibit both metallic and ceramic characteristics under various conditions. Of particular interest for IC devices, MAX materials have high electrical conductivity due to the metallic-like nature of their bonding. They also have high thermal shock resistance, damage tolerance, machinability, elastic stiffness, and low thermal expansion coefficients. Certain MAX materials are highly resistant to chemical attack and high-temperature oxidation.

MX materials, also referred to as MXenes, are two-dimensional compounds that are synthesized from a MAX material or another layered precursor by selectively etching out the A-group element. MX materials have the general formula Mₙ₊₁Xₙ, where n=1 to 4, M is an early transition metal, and X is carbon or nitrogen. In some cases, the surface of a MX material may be terminated by a functional group, referred to as T, such as oxygen (O), fluoride (F), a hydroxy group (OH), or chlorine (CI). Adding functional groups can tune the band gap of MX materials. In addition, double transition metal MX materials, which include two different early transition metals, have been synthesized. Double transition metal MX materials include, for example, Mo₂TiC₂, Mo₂Ti₂C₃, Cr₂TiC₂, and MO₄VC₄. MX materials also have high conductivity and low resistance. The conductivity of MX materials may be similar to or higher than graphene.

MAX and MX materials can both be formed in very thin layers (e.g., less than 5 nanometers in height), which makes them suitable materials for IC devices produced with increasingly small dimensions. For example, as described herein, MAX or MX materials can be used to form device contacts (e.g., source/drain contacts) and interconnects, such as lines and vias. MAX or MX materials can replace traditional conductive materials, such as copper, in IC device. In other examples, the material properties of MAX or MX materials enable them to be used along with traditional conductors in various barrier or cap applications, e.g., in place of tantalum or tantalum nitrides as a barrier layer, or as an interconnect capping material to improve specular scattering.

The conductive regions formed from MX or MAX materials described herein may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### MAX and MX material structures

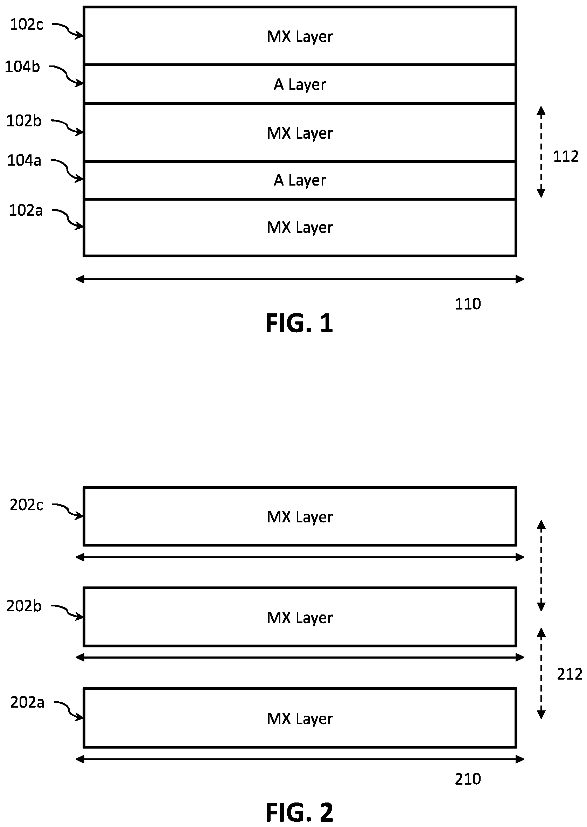

FIG. 1 is a cross-section showing a general structure of a layered MAX material, according to some embodiments of the present disclosure. As noted above, MAX materials, also referred to as MAX phases, are layered, hexagonal carbides and nitrides that have the general formula Mₙ₊₁AXₙ, where n=1 to 4, and M is an early transition metal, A is an A group element, and X is either carbon or nitrogen. More specifically, M may be an element from group 3 through 6 in the periodic table, e.g., scandium (Sc), titanium (Ti), zirconium (Zr), hafnium (Hf), vanadium (V), niobium (Nb), tantalum (Ta), chromium (Cr), or molybdenum (Mo). The A group element is from the A group of the periodic table, also referred to as the main group, and is typically from group 13 or 14 from the periodic table. The A group element may be, for example, cadmium (Cd), aluminum (Al), gallium (Ga), indium (In), thallium (TI), silicon (Si), germanium (Ge), tin (Sn), lead (Pb), phosphorus (P), arsenic (As), or sulfur (S).

The MAX material is formed in multiple layers of MX and A. FIG. 1 illustrates three MX layers 102a, 102b, and 102c (referred to jointly as MX layers 102) and two A layers 104a and 104b (referred to jointly as A layers 104). The MX layers 102 include M atoms and X atoms arranged in a hexagonal structure. The structure of an individual MX layer 102 depends on the chemical formula of the MAX material, e.g., an MX layer for M₄AX₃ is typically thicker than an MX layer for M₂AX. An A layer 104 formed from A atoms is between adjacent MX layers 102, e.g., the A layer 104 is between the MX layers 102a and 102.

MAX materials have high electrical conductivity due to the metallic-like nature of their bonding. MAX materials have a high electrical conductivity along the layers, e.g., in the direction 110 indicated by a solid arrow in FIG. 1. MAX materials have a lower electrical conductivity between layers, e.g., in the direction 112 indicated by the dashed arrow in FIG. 1.

MX materials, or MXenes, can be formed from MAX materials. MX materials have the general formula Mₙ₊₁Xₙ, where n=1 to 4, M is an early transition metal (e.g., any of the early transition metals listed above), and X is carbon or nitrogen. In some cases, the surface of a MX material may be terminated by a functional group, referred to as T, such as O, F, OH, or CI; the general formula for a MX material with a functional group T is Mₙ₊₁XₙTₓ. In addition, double transition metal MX materials, which include two different early transition metals, have been synthesized. Double transition metal MX materials may have a general formula M'₂M"C₂ or M'₂M"₂C₃, where M' and M" are different transition metals. Example double transition metal MX materials include, for example, Mo₂TiO₂, Mo₂Ti₂C₃, Cr₂TiC₂, and MO₄VC₄.

FIG. 2 is a cross-section showing a general structure of a layered MX material, according to some embodiments of the present disclosure. FIG. 2 illustrates three MX layers 202a, 202b, and 202c (referred to jointly as MX layers 202), where the individual MX layers 202 are similar to the MX layers 102 discussed with respect to FIG. 1. MX materials may be synthesized from MAX materials using a top-down selective etching process. For example, an MX material may be formed from a MAX material by using a strong etching solution that contains a fluoride ion (F-) such as hydrofluoric acid (HF), ammonium bifluoride (NH₄HF₂), or a mixture of hydrochloric acid (HCI) and lithium fluoride (LiF). For example, etching of Ti₃AlC₂ in aqueous HF at room temperature causes the aluminum atoms (e.g., atoms in an A layer 104) to be selectively removed. The surface of the carbide layers may become terminated by a functional group, e.g., O, OH, and/or F atoms. Alternatively, an MX material can also be obtained using a Lewis acid molten salt, such as ZnCl₂.

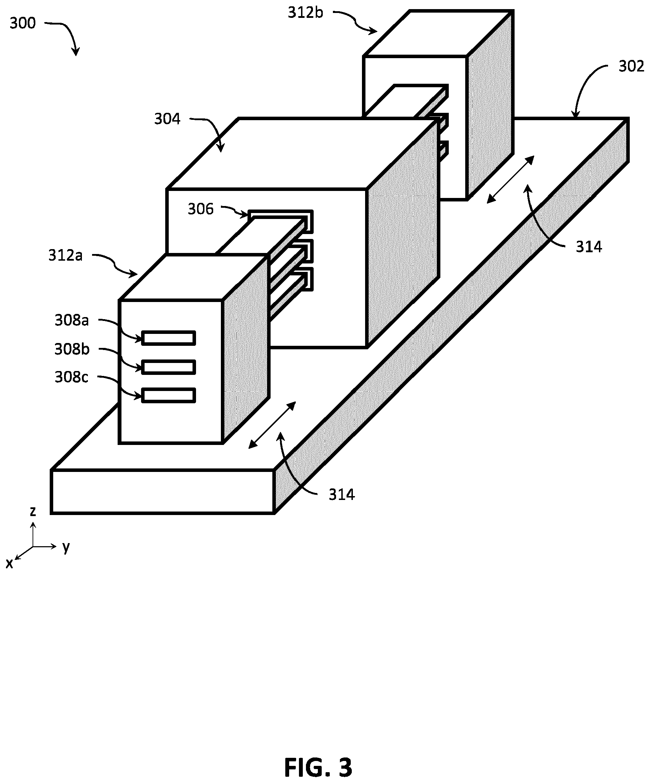

Three MX layers 202 are illustrated in FIG. 3, but MX can be formed with structures having more or fewer layers. MX materials may be referred to as multi-layered MXenes (ML-MXenes) if they include, e.g., more than five layers, or few-layered MXenes (FL-MXenes) if they include, e.g., five or fewer layers. Each MX layer 202 may have a thickness of around 1 nanometer, depending on the general formula (e.g., with a MX layer of an M₄AX₃ typically thicker than an MX layer for M₂AX), and depending on the particular elements included in the MX layer 202.

Like MAX materials, MX materials have high conductivity and low resistance. For example, the conductivity of a MX material may be similar to or higher than graphene. MX materials have a high electrical conductivity along the layers, e.g., in the direction 210 indicated by the solid arrows in FIG. 2. MX materials have a lower electrical conductivity between layers, e.g., in the direction 212 indicated by the dashed arrows in FIG. 2.

### Example nanoribbon transistor with MX or MAX contacts

FIG. 3 is a perspective view illustrating an example arrangement of a nanoribbon transistor 300 with a MX or MAX material forming the source and drain contacts, according to some embodiments of the present disclosure. The transistor 300 may be implemented as a stand-alone transistor, or the transistor 300 may be included as a part of a memory cell (e.g., the transistor 300 may be an access transistor coupled to a capacitor, forming a one-transistor one-capacitor (1T-1C) memory cell). The transistor 300 may be included in various regions/locations in an IC device. For example, the transistor 300 may be used as, e.g., a logic transistor in a compute logic layer. In another example, the transistor 300 may be used as, e.g., an access transistor in a memory layer.

In general, a transistor is a three-terminal device that includes source, drain, and gate terminals and uses electric field to control current flowing through the device. A transistor typically includes a channel material, a source region, and a drain region provided in the channel material, and a gate stack that includes a gate electrode material, alternatively referred to as a "work function" (WF) material. The gate stack is coupled to a portion of the channel material between the source and the drain regions. The gate stack may also include a gate dielectric material between the gate electrode material and the channel material.

One example transistor architecture is a nanoribbon-based transistor (or, simply, a nanoribbon transistor, e.g., a nanowire transistor). In a nanoribbon transistor, a gate stack that may include a stack of one or more gate electrode metals and, optionally, a stack of one or more gate dielectrics may be provided around one or more elongated semiconductor structures called "nanoribbons", forming a gate on all sides of the nanoribbon or nanoribbons. A portion of a nanoribbon around which the gate stack wraps around is referred to as a "channel" or a "channel portion." A semiconductor material of which the channel portion of the nanoribbon is formed is commonly referred to as a "channel material." A source region and a drain region are provided on the opposite ends of the nanoribbon, on either side of the gate stack, forming, respectively, a source and a drain of such a transistor. Wrap-around or all-around gate transistors, such as nanoribbon and nanowire transistors, may provide advantages compared to other transistors having a non-planar architecture, such as FinFETs.

The arrangement shown in FIG. 3 is intended to show relative arrangements of some of the components therein, and that the arrangement with the transistor 300, or portions thereof, may include other components that are not illustrated. For example, although not specifically illustrated in FIG. 3, a dielectric spacer may be provided between the first S/D contact 312a and the gate stack as well as between the second S/D contact 312b and the gate stack in order to provide electrical isolation between the source, gate, drain electrodes. In another example, although not specifically illustrated in FIG. 3, at least portions of the transistor 300 may be surrounded in an insulator material, such as any suitable interlayer dielectric (ILD) material. In some embodiments, such an insulator material may be a high-k dielectric material or a low-k dielectric material.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

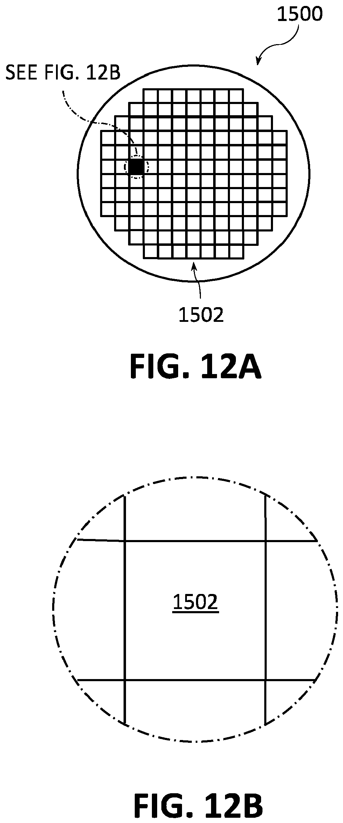

In general, implementations of the present disclosure may be formed or carried out on a support structure, e.g., the support structure 302 illustrated in FIG. 3. The support structure 302 may be, e.g., a substrate, a die, a wafer or a chip. For example, the support structure may be the wafer 1500 of FIG. 12A, discussed below, and may be, or be included in, a die, e.g., the singulated die 1502 of FIG. 12B, discussed below. In some embodiments, the support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more MX or MAX conductive regions, as described herein, may be built falls within the scope of the present disclosure.

Turning to the details of FIG. 3, the transistor 300 may include a channel material formed as one or more nanoribbons 308. In the example shown in FIG. 3, the channel includes three nanoribbons 308a, 308b, and 308c. In other embodiments, more or fewer nanoribbons 308 may be included. The nanoribbons 308 are stacked on top of each other and over the support structure 302, with spaces between adjacent nanoribbons 308 and between the lowest nanoribbon 308c and the support structure 302. The distance between adjacent nanoribbons (e.g., the distance between the nanoribbons 308a and 308b) can be quite small, e.g., between 5 and 20 nanometers, or in some examples, between 7 and 10 nanometers. In the example shown in FIG. 3, the nanoribbons 308 extend in a direction parallel to the support structure 302. In the example coordinate system shown in FIG. 3, the nanoribbons 308 extend in the x-direction. In other embodiments, the nanoribbons 308 may be oriented, e.g., "vertically", so as to be perpendicular to a plane of the support structure 302.

The nanoribbons 308 may take the form of a nanowire or nanoribbon, for example. Although the nanoribbons 308 illustrated in FIG. 3 are shown as having rectangular cross-sections, a nanoribbon 308 may instead have a cross-section that is rectangular but not square, a cross-section that is rounded at corners or otherwise irregularly shaped.

The nanoribbons 308 may be formed from one or more semiconductor materials, including, for example, N-type or P-type materials systems. In some embodiments, the nanoribbons 308 are formed from a transition metal dichalcogenide (TMD). TMDs are atomically thin semiconductors having the general formula MX₂, where M is a transition metal such as Mo or W, and X is a chalcogen atom (S, selenium (Se), or tellurium (Te)). Like MX and MAX materials, TMDs are very thin, e.g., a MoS₂ monolayer has a thickness of 6.5 angstroms.

In other embodiments, the channel material forming the nanoribbons 308 may include a semiconductor material, such as tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, indium gallium zinc oxide (IGZO), indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material may include a monocrystalline semiconductor, such as silicon (Si) or germanium (Ge). In some embodiments, the channel material may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 300 is an NMOS), the channel material may advantageously include a III-V material having a high electron mobility, such as, but not limited to InGaAs, InP, InSb, and InAs. For some such embodiments, the channel material may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel material may be an intrinsic III-V material, i.e., a III-V semiconductor material not intentionally doped with any electrically active impurity. In alternate embodiments, a nominal impurity dopant level may be present within the channel material, for example to further fine-tune a threshold voltage Vt, or to provide HALO pocket implants, etc. Even for impurity-doped embodiments however, impurity dopant level within the channel material may be relatively low, for example below 10¹⁵ dopant atoms per cubic centimeter (cm⁻³), and advantageously below 10¹³ cm⁻³.

For some example P-type transistor embodiments (i.e., for the embodiments where the transistor 300 is a PMOS), the channel material may advantageously be a group IV material having a high hole mobility, such as, but not limited to Ge or a Ge-rich SiGe alloy. For some example embodiments, the channel material may have a Ge content between 0.6 and 0.9, and advantageously may be at least 0.7. In some embodiments with highest mobility, the channel material may be intrinsic III-V (or IV for P-type devices) material and not intentionally doped with any electrically active impurity. In alternate embodiments, one or more a nominal impurity dopant level may be present within the channel material, for example to further set a threshold voltage (Vt), or to provide HALO pocket implants, etc. Even for impurity-doped embodiments however, impurity dopant level within the channel portion is relatively low, for example below 10¹⁵ cm⁻³, and advantageously below 10¹³ cm⁻³.

The nanoribbons 308 may include a first and a second S/D region (together referred to as "S/D regions") on either side of the gate stack, thus realizing a transistor. As is known in the art, source and drain regions (also sometimes interchangeably referred to as "diffusion regions") are formed for the gate stack of a transistor. In some embodiments, the S/D regions may be regions of doped semiconductors, e.g., regions of channel material are doped with a suitable dopant to a suitable dopant concentration, so as to supply charge carriers for the transistor channel. In some embodiments, the S/D regions may be highly doped, e.g. with dopant concentrations of about 1·10²¹ cm⁻³, in order to advantageously form Ohmic contacts with the respective S/D contacts 312 (described below), although, in other embodiments, these regions may also have lower dopant concentrations and may form Schottky contacts in some implementations. Irrespective of the exact doping levels, the S/D regions may be the regions having dopant concentration higher than in other regions, e.g., higher than a dopant concentration in a region of the nanoribbons 308 encased by the gate electrode 304, and, therefore, may be referred to as "highly doped" (HD) regions. In some embodiments, the S/D regions may generally be formed using an implantation/diffusion process. In this process, dopants such as boron, aluminum, antimony, phosphorous, or arsenic may be ion-implanted into the one or more semiconductor materials of the channel material to form the S/D regions. An annealing process that activates the dopants and causes them to diffuse further into the channel material may follow the ion implantation process.

A gate stack including a gate electrode 304 and, optionally, a gate dielectric 306, may wrap entirely or almost entirely around each of the nanoribbons 308, with the active region of the channel material of the nanoribbon 308 corresponding to the portion of the nanoribbon 308 wrapped by the gate stack. For example, the gate dielectric 306 may wrap around a transversal portion of each nanoribbon 308, and the gate electrode 304 may wrap around the gate dielectric 306. In some embodiments, the gate stack may fully encircle the nanoribbons 308.

The gate electrode 304 may include at least one P-type work function metal or N-type work function metal. For a PMOS transistor, metals that may be used for the gate electrode 304 may include, but are not limited to, ruthenium, palladium, platinum, cobalt, nickel, and conductive metal oxides (e.g., ruthenium oxide). For an NMOS transistor, metals that may be used for the gate electrode 304 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 304 may include a stack of two or more metal layers, where one or more metal layers are WF metal layers and at least one metal layer is a fill metal layer.

In various embodiments, the gate dielectric 306 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 306 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 306 during manufacture of the transistor 300 to improve the quality of the gate dielectric 306. In some embodiments, the gate dielectric 306 may have a thickness between about 0.5 nanometers and 3 nanometers, including all values and ranges therein, e.g., between about 1 and 3 nanometers, or between about 1 and 2 nanometers.

In some embodiments, the gate stack may be surrounded by a gate spacer, not shown in FIG. 3. Such a gate spacer would be configured to provide separation between the gate electrode 304 and the source/drain contacts 312 of the transistor 300 and could be made of a low-k dielectric material, some examples of which have been provided above. A gate spacer may include pores or air gaps to further reduce its dielectric constant.

As further shown in FIG. 3, S/D contacts 312a and 312b (together referred to as "S/D contacts 312"), which are formed of one or more electrically conductive materials, may be used for providing electrical connectivity to the S/D regions of the nanoribbons 308. In particular, one or both of the S/D contacts 312 may include a MAX material or MX material, as described above with respect to FIGs. 1 and 2. The S/D contacts 312 are formed around and between the nanoribbons 308, e.g., a portion (e.g., one or more layers) of the MAX or MX material are formed between the nanoribbons 308a and 308b. In some embodiments, the contacts 312 may include a MAX or MX material in combination with one or more layers of other materials, e.g., metals and/or metal alloys.

As described with respect to FIGs. 1 and 2, MAX and MX materials are formed in layered structures, with greater conductivity within a given layer than between two layers. The layers of the MAX or MX material may be arranged parallel to the support structure 302 and the nanoribbons 308. A primary direction of electrical conduction within the S/D contacts 312 is illustrated by the arrows 314. The direction 314 is based on the orientation of the layers and the direction of charge flow through the nanoribbons 308, which is in the x-direction in the coordinate system shown in FIG. 3. As discussed above, very thin layers of MAX material or MX materials can be formed. These materials can be used in combination with thin channel materials, such as TMDs, to form extremely thin transistors.

### Example transistor with back-side or front-side contacts including MX or MAX materials

MAX or MX material can be included in other transistor architectures, such as planar transistors in which a channel region, dielectric, and gate electrode are stacked. Planar transistors can be made in various different arrangements, including an arrangement in which the S/D contacts are formed on the front side of the device, and an arrangement in which the S/D contacts are formed on the back side of the device. Other implementations may have one front-side and one back-side contact.

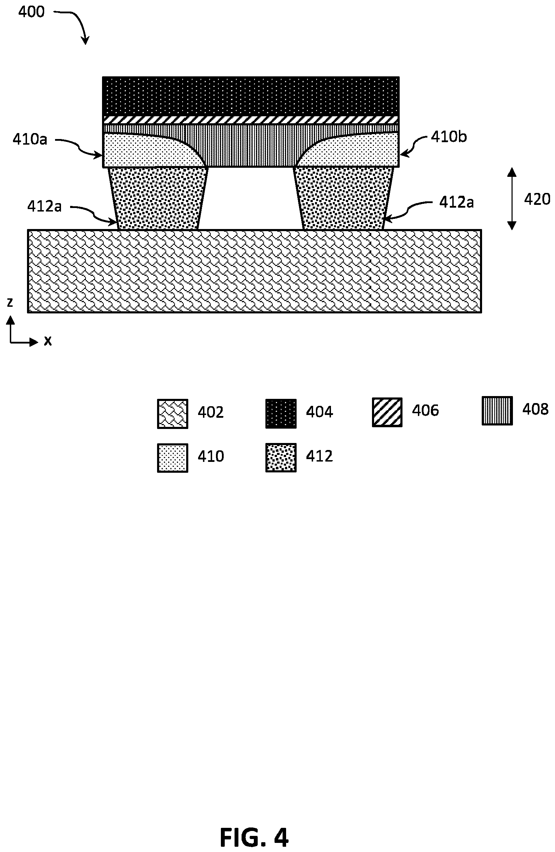

FIG. 4 is a cross-sectional view showing an example arrangement of a planar transistor 400 with back-side contacts that may include a MX or MAX material, according to some embodiments of the present disclosure. The transistor 400 is formed over a support structure 402, which may be similar to the support structure 302 described above. The transistor 400 coupled to a pair of S/D contacts 412a and 412b, where the S/D contacts 412 include an MX or MAX material. In some embodiments, one of the S/D contacts 412 (e.g., the contact 412b) may be coupled to a capacitor (not shown in FIG. 4) for storing a bit of data. In such embodiments, the transistor 400 is an access transistor that controls access to the capacitor to write information to the capacitor or to read information from the capacitor.

A number of elements referred to in the description of FIGs. 4-10 with reference numerals are illustrated in these figures with different patterns, with a legend showing the correspondence between the reference numerals and patterns being provided at the bottom or side of each drawing page containing FIGs. 4-10. For example, the legend in FIG. 4 illustrates that FIG. 4 uses different patterns to show a support structure 402, a gate electrode 404, a gate dielectric 406, a channel material 408, S/D regions 410, and S/D contacts 412.

The transistor 400 includes a gate electrode 404, a gate dielectric 406, a channel material 408, and two S/D regions 410. If the transistor 400 is an access transistor for a memory cell, the gate electrode 404 may be coupled to a WL, e.g., via a gate via not specifically shown in FIG. 4. The WL may be coupled to a row of similar transistors. A first S/D region 410a is coupled to a first S/D contact 412a, and a second S/D region 410b is coupled to a second S/D contact 412b. The first S/D contact 412a may be coupled to a BL that is coupled to a column of similar transistors. The second S/D contact 412a may be coupled to one electrode of a capacitor, as noted above. The capacitor may have a second electrode coupled to a plateline (PL), also not shown in FIG. 4, as is known in the art.

The gate electrode 404 and the gate dielectric 406 form a gate stack. The gate electrode 404 may include at least one P-type work function metal or N-type work function metal, depending on whether the transistor 400 is a PMOS transistor or an NMOS transistor (P-type work function metal used as the gate electrode 404 when the transistor 400 is a PMOS transistor and N-type work function metal used as the gate electrode 404 when the transistor 400 is an NMOS transistor). The gate electrode 404 may include, for example, any of the materials described above with respect to the gate electrode 304.

In some embodiments, the gate dielectric 406 may include one or more high-k dielectrics, e.g., any of the high-k dielectrics described with respect to the gate dielectric 306. In some embodiments, the gate dielectric 406 may consist of a stack of two or more dielectric layers, e.g., a stack of two or more of the high-k materials listed above. The gate dielectric 406, or a layer of the gate dielectric 406, may comprise a mixture of the materials listed above and/or of other oxides, nitrides, or oxynitrides.

The gate dielectric 406 may be deposited using a conformal deposition process, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces. In some embodiments, an annealing process may be carried out on the gate dielectric 406 during manufacture of the transistor 400 to improve the quality of the gate dielectric 406. The gate dielectric 406 may have a thickness, a dimension measured in the direction of the z-axis of the reference coordinate system x-y-z shown in FIG. 4, that may, in some embodiments, be between 0.5 nanometers and 20 nanometers, including all values and ranges therein (e.g., between 2 and 6 nanometers).

The channel material 408 may be composed of semiconductor material systems including, for example, N-type or P-type materials systems. In certain embodiments, the channel material 408 is or includes a TMD. In certain other embodiments, the channel material 408 is or includes silicon or germanium, e.g., a monocrystalline silicon or monocrystalline germanium. More generally, the channel material 408 may include any of the channel materials described with respect to the nanoribbons 308.

In some embodiments, the transistor 400 may be a thin film transistor (TFT). A TFT is a special kind of a field-effect transistor made by depositing a thin film of an active semiconductor material, as well as a dielectric layer and metallic contacts, over a supporting layer that may be a non-conducting layer. At least a portion of the active semiconductor material forms a channel of the TFT. If the transistor 400 is a TFT, the channel material 408 may include a high mobility oxide semiconductor material, such as tin oxide, antimony oxide, indium oxide, indium tin oxide, titanium oxide, zinc oxide, indium zinc oxide, IGZO, gallium oxide, titanium oxynitride, ruthenium oxide, aluminum zinc oxide, or tungsten oxide. In general, if the transistor 400 is a TFT, the channel material 408 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antonomide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc. In some embodiments, the channel material 408 may have a thickness between about 5 and 75 nanometers, including all values and ranges therein. In some embodiments, a thin film channel material 408 may be deposited at relatively low temperatures, which allows depositing the channel material 408 within the thermal budgets imposed on back-end fabrication to avoid damaging other components, e.g., front end components such as the logic devices.

The S/D regions 410 are formed in the channel material 408. The S/D regions 410 may generally be formed using either an implantation/diffusion process or an etching/deposition process. In the former process, dopants such as boron, aluminum, antimony, phosphorous, or arsenic may be ion-implanted into the channel material to form the S/D regions 410. An annealing process that activates the dopants and causes them to diffuse further into the channel material 408 typically follows the ion implantation process. In the latter process, the channel material 408 may first be etched to form recesses at the locations of the S/D regions 410. An epitaxial deposition process may then be carried out to fill the recesses with material that is used to fabricate the S/D regions 410. In some implementations, the S/D regions 410 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 410 may be formed using one or more alternate semiconductor materials such as germanium or a group III-V material or alloy. And in further embodiments, one or more layers of metal and/or metal alloys may be used to form the S/D regions 410.

The S/D contacts 412 are coupled to the channel material 408, and in particular, to the S/D regions 410. The first S/D contact 412a is coupled to the first S/D region 410a, and the second S/D contact 412b is coupled to the second S/D region 410b. The S/D contacts 412 may have a thickness measured in the z-direction in the reference coordinate system shown in FIG. 4 of between, for example, 1 nanometers and 50 nanometers, including all values and ranges therein.

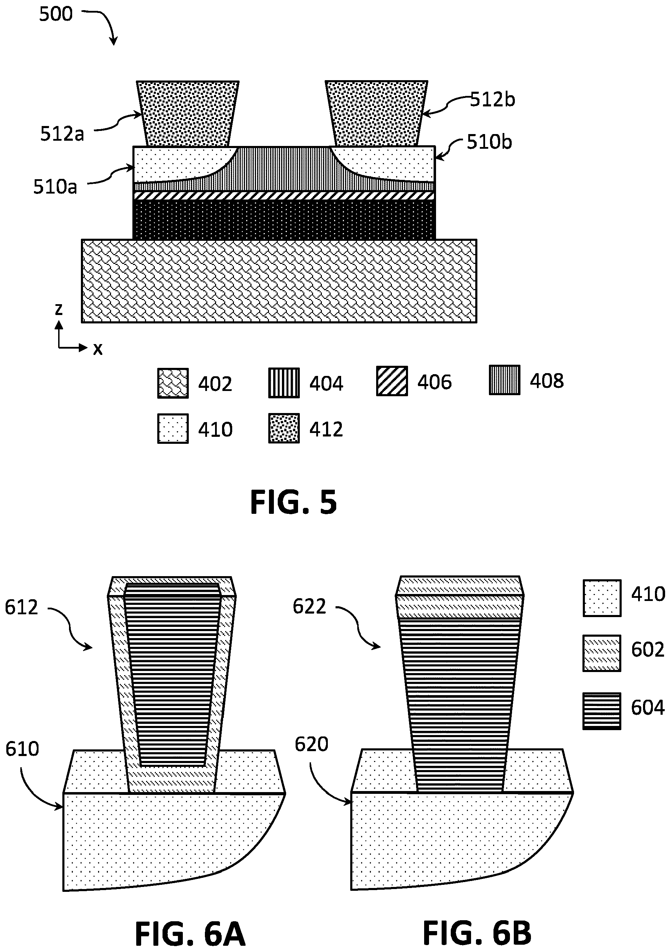

An insulator material (not shown in FIG. 4) may be formed between the S/D contacts 412 and electrically separate the two S/D contacts 412a and 412b. The insulator material may be formed as a layer under and/or around the transistor 400 and similar transistors, where the insulator material layer further electrically separates transistors from one another. In the configuration shown in FIG. 4, the S/D contacts 412 are on the back side of the transistor 400, i.e., on the side of the transistor 400 closer to the support structure 402. The gate stack is on the front side of the transistor 400, i.e., on the side of the transistor 400 farther from the support structure 402. In another embodiment, illustrated in FIG. 5, the transistor is flipped relative to the transistor 400, with the S/D contacts on the front side and the gate stack on the back side.

The S/D contacts 412 may advantageously be formed from a MAX or MX material, described above with respect to FIGs. 1 and 2. In some embodiments, the S/D contacts 412 may be formed of multiple layers of a MAX material (e.g., multiple MX layers 102 with A layers 104 between the MX layers 102) or multiple layers of an MX material (e.g., multiple MX layers 202). The layers may be oriented perpendicular to the support structure 402, providing high conductivity in the z-direction in the coordinate system shown in FIG. 4. The direction of current flow through the S/D contacts 412 is illustrated by the arrow 420 in FIG. 4. Orienting the layers so that current flows in the direction 420 directs current into and/or out of the S/D regions 410. In other embodiments, the layers may be oriented parallel to the support structure 402.

In other embodiments, rather than forming the full S/D contacts 412 from a MAX or MX material, some portion of the S/D contacts 412 include a MAX or MX material, while another portion of the S/D contacts 412 includes one or more other materials, such as one or more metals or metal alloys. Examples of S/D contacts that include a MAX or MX region are illustrated in FIGs. 6A and 6B.

FIG. 5 is a cross-sectional view showing an example arrangement of transistor 500 with front-side contacts that may include a MX or MAX material, according to some embodiments of the present disclosure. The transistor 500 includes the materials described with respect to FIG. 4, including the support structure 402, gate electrode 404, gate dielectric 406, channel material 408, S/D regions 410, and S/D contacts 412, in a different arrangement than in the transistor 400.

The transistor 500 includes a gate electrode 404 formed on the back side of the transistor 500. The gate dielectric 406 is formed over the gate electrode 404, and the channel material 408 is formed over the gate dielectric 406. The two S/D regions 410 are formed in the channel material 408. In the transistor 500, two S/D contacts 412 that include a MAX or MX material are positioned on the front side of the transistor 500. The two S/D contacts are labelled 512a and 512b, and they are formed over two S/D regions are labelled 510a and 510b. The transistor 500 is flipped relative to the transistor 400, with the S/D regions 510a and 510b and S/D contacts 512a and 512b at the back side of the transistor 500, and the gate stack at the front side of the transistor 500.

FIGs. 4 and 5 illustrate two example transistor architectures that may include MAX or MX materials in the S/D contacts. As noted with respect to FIG. 3, the MAX and MX materials described herein may be used with other transistor architectures, e.g., architectures with one front-side contact and one back-side contact, architectures with a gate stack formed between two front-side S/D contacts, architectures with a gate stack formed between two back-side contact, etc.

### Example contacts with MX or MAX material regions

FIG. 6A and 6B illustrate two example arrangements of source and drain contacts that include a MX or MAX material, according to some embodiments of the present disclosure. In some embodiments, S/D contacts, such as the S/D contacts 412 and S/D contacts 512 shown FIGs. 4 and 5, may include a barrier region and a conductive region, e.g., an inner conductive structure that is surrounded by a barrier region. The barrier region separates the inner conductive structure, which may include copper, titanium, or other conductive materials, from the S/D regions 410 or 510. The barrier region can prevent or reduce interactions between the material in the inner conductive region and the S/D regions. For example, if the S/D regions include silicon, the barrier region may prevent the formation of silicide, which creates resistivity between the S/D contacts and the S/D region. As another example, if the S/D regions include oxygen and a metal that forms relatively weak metal-oxygen bonds, some typical S/D materials may draw oxygen atoms out of the channel and towards the S/D contact, degrading the channel. A barrier region may protect the channel material from a metal in the inner conductive structure of the S/D contact.

FIG. 6A illustrates an example S/D region 610 (e.g., the S/D region 510a) with an S/D contact 612 (e.g., the S/D contacts 512a) formed over the S/D region 610. While FIG. 6A illustrates a front-side contact, a back-side contact (e.g., the S/D contacts 412 illustrated in FIG. 4) may be formed with a similar structure and flipped relative to the orientation shown in FIG. 6A. The contact 612 includes a MAX/MX region 602 and a conductive structure 604. The conductive structure 604 may be, e.g., a metal core (e.g., copper). The conductive structure 604 may further include one or more layers of different materials, e.g., a titanium layer and/or a titanium nitride layer.

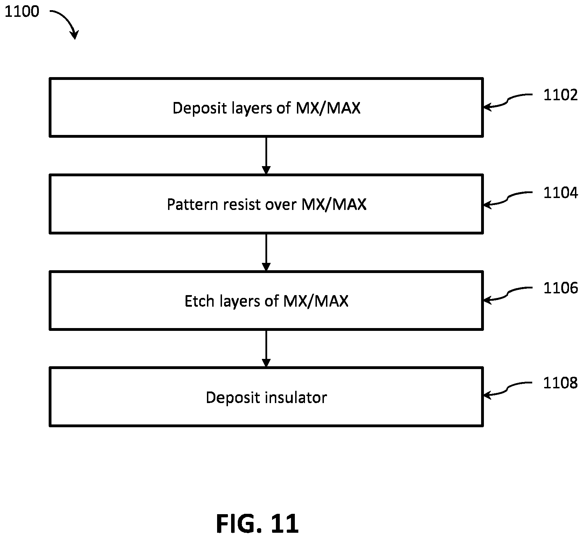

The MAX/MX region 602 includes a MAX or MX material, as described above with respect to FIGs. 1 and 2. The MAX or MX material may be formed in multiple layers (e.g., multiple MX layers 102 with A layers 104 between the MX layers 102, or multiple MX layers 202). In some embodiments, the MAX or MX material are deposited using a conformal deposition method within a contact hole, forming the structure illustrated in FIG. 6A, such that the MAX/MX region 602 is a barrier region extending up the sides of the contact 612. In some embodiments, the MAX/MX region 602 (or one or more individual layers of the MAX/MX region 602) may not extend up the full height of the contact 612. For example, the MAX/MX region 602 may be formed over the S/D region 610, and the conductive structure 604 is formed over top of the MAX/MX region 602. In this example, the MAX/MX region 602 may be deposited using a non-conformal deposition method, or layer-transferred over a transistor. In some embodiments, the MAX or MX material is formed using a subtractive process, as described with respect to FIG. 11.

The MAX/MX region 602 is coupled between the S/D region 610 and the conductive structure 604. The MAX/MX region 602 may have a thickness of one or a few layers (e.g., a FL-MXene), or more layers (e.g., a ML-MXene). For example, the MAX/MX region 602 may have a thickness of less than 5 nanometers, or less than 2 nanometers. In some embodiments, the MAX/MX region 602 may include multiple layered MAX and/or MX materials. The layers may be oriented parallel to the support structure (e.g., stacked over the S/D region 610), perpendicular to the support structure (e.g., providing high conductivity into or out of the S/D region 610), or in another orientation.

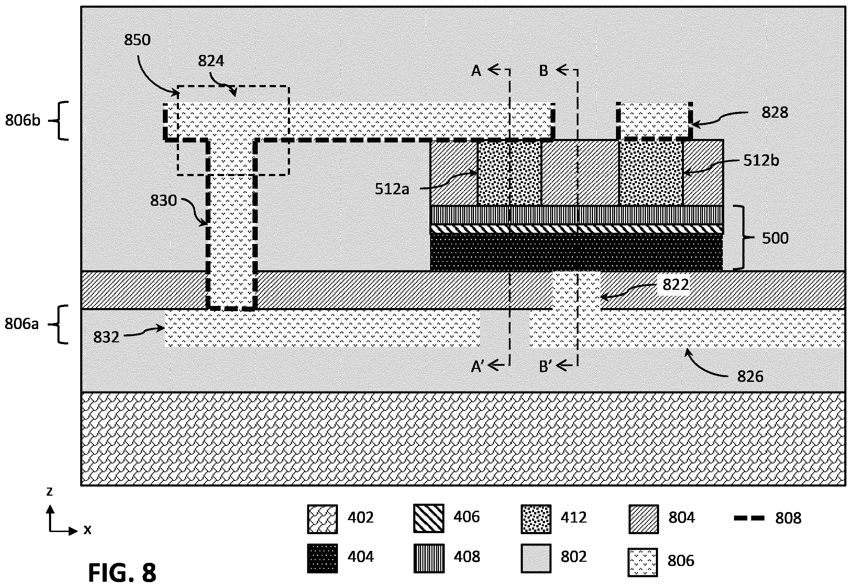

In some embodiments, S/D contacts, such as the S/D contacts 412 and S/D contacts 512 shown FIGs. 4 and 5, may include a conductive region with a cap. The conductive region is between the cap and the S/D region, and the cap may be between the conductive region and another structure, such as an interconnect. FIG. 8, discussed below, shows an example of interconnect coupled to S/D contacts. A cap formed of a MAX or MX material may lead to resistance gains (e.g., lower resistance between the S/D contacts and the interconnect). For example, the MAX or MX cap may reducing surface scattering, i.e., reducing scattering of electrons off the surface of the S/D contact).

FIG. 6B illustrates an example S/D region 620 (e.g., the S/D region 510a) with an S/D contact 622 (e.g., the S/D contacts 512a) formed over the S/D region 620. While FIG. 6B illustrates a front-side contact, a back-side contact (e.g., the S/D contacts 412 illustrated in FIG. 4) may be formed with a similar structure and flipped relative to the orientation shown in FIG. 6B. The contact 622 includes an MAX/MX region 602 and a conductive structure 604. In this example, the MAX/MX region 602 is over the conductive structure 604, forming a cap for the conductive structure 604 rather than a barrier region (as illustrated in FIG. 6A). The conductive structure 604 may further include one or more layers of different materials, e.g., a titanium barrier layer and/or a titanium nitride barrier layer. In some embodiments, the conductive structure 604 includes an MAX or MX barrier region, as shown in FIG. 6A.

The conductive structure 604 may be, e.g., a metal core (e.g., copper). In some embodiments, the conductive structure 604 may be a copper alloy, e.g., a copper and manganese (Mn) or copper and aluminum (Al) alloy. An alloy may improve adhesion between the conductive structure 604 and the MAX/MX region 602. In other embodiments, the conductive structure 604 may include doped copper or a doped copper alloy, e.g., copper doped with aluminum or silicon.

The MAX or MX material in the MAX/MX region 602 may be formed in multiple layers (e.g., multiple MX layers 102 with A layers 104 between the MX layers 102, or multiple MX layers 202). The MAX/MX region 602 may be deposited using a conformal or non-conformal deposition method over the conductive structure 604, or using a subtractive process as described with respect to FIG. 11.

The MAX/MX region 602 may have a thickness of one or a few layers (e.g., a FL-MXene), or more layers (e.g., a ML-MXene). For example, the MAX/MX region 602 may have a thickness of less than 5 nanometers, or less than 2 nanometers. In some embodiments, the MAX/MX region 602 may include multiple layered MAX and/or MX materials. The layers may be oriented parallel to the support structure (e.g., stacked over the S/D region 610), which can be used to form a very thing cap. Alternatively, the layers may be oriented perpendicular to the support structure (e.g., providing high conductivity into or out of the S/D region 610), or in another orientation. In some embodiments, the MAX/MX region 602 may be a partial MAX/MX layer, with the MAX or MX material covering a portion of the conductive structure 604. In some embodiments, one or more additional materials may be included under or over the MAX/MX region 602, forming a cap with multiple regions. For example, a cobalt layer may be formed between the conductive structure 604 and the MAX/MX region 602.

### Example FinFET with contacts including MX or MAX materials

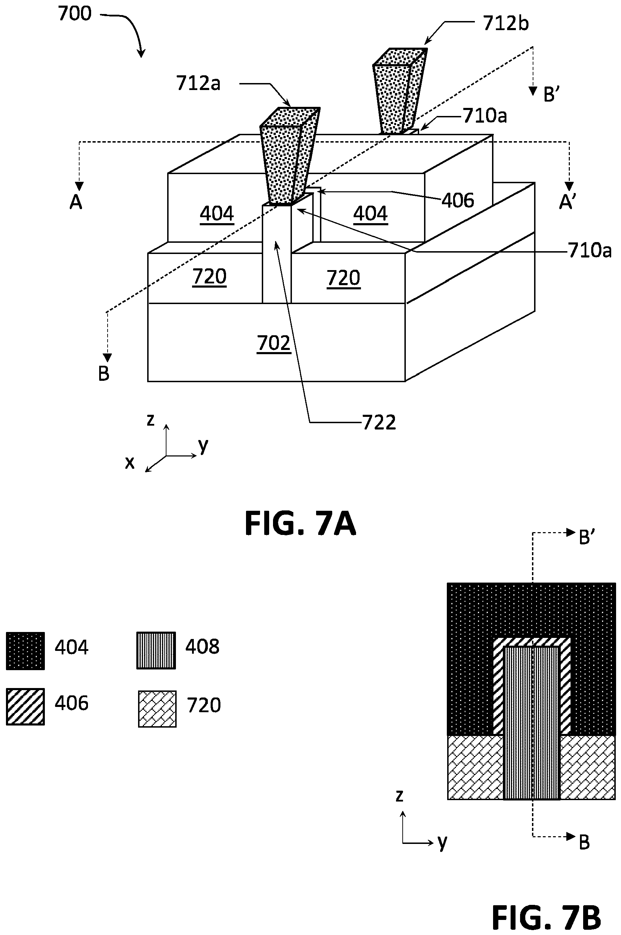

As noted above, the MAX and MX materials described herein can be used in a variety of transistor architectures. FIGs. 7A-7B are perspective and cross-sectional views, respectively, of an example transistor implemented as a FinFET with source and drain contacts that may include a MX or MAX material, according to some embodiments of the present disclosure.

FinFETs refer to transistors having a non-planar architecture where a fin, formed of one or more semiconductor materials, extends away from a base (where the term "base" refers to any suitable support structure on which a transistor may be built, e.g., a substrate). A portion of the fin that is closest to the base may be enclosed by an insulator material. Such an insulator material, typically an oxide, is commonly referred to as a "shallow trench isolation" (STI), and the portion of the fin enclosed by the STI is typically referred to as a "subfin portion" or simply a "subfin." A gate stack that includes at least a layer of a gate electrode material and, optionally, a layer of a gate dielectric may be provided over the top and sides of the remaining upper portion of the fin (i.e., the portion above and not enclosed by the STI), thus wrapping around the upper-most portion of the fin. The portion of the fin over which the gate stack wraps around is typically referred to as a "channel portion" of the fin because this is where, during operation of the transistor, a conductive channel forms, and is a part of an active region of the fin. Two S/D regions are provided on the opposite sides of the gate stack, forming a source and a drain terminal of a transistor. FinFETs may be implemented as "tri-gate transistors," where the name "tri-gate" originates from the fact that, in use, such transistors may form conducting channels on three "sides" of the fin. FinFETs potentially improve performance relative to single-gate transistors and double-gate transistors.

FIG. 7A is a perspective view, while FIG. 7B is a cross-sectional side view of a FinFET 700 that may include MAX or MX materials, e.g., in the S/D contacts. FIGS. 7A-7B illustrate the support structure 402, gate electrode 404, gate dielectric 406, channel material 408, and S/D regions 410 as described with respect to FIGs. 4 and 5. The two S/D regions are labeled as 710a and 710b in FIG. 7A. As shown in FIGS. 7A-7B, when the transistor 700 is implemented as a FinFET, the FinFET 700 may include a fin 722, and an STI material 720 enclosing the subfin portion of the fin 722. Two S/D contacts 712a and 712b are further shown in FIGS. 7A-7B. The contacts 712a and 712b may incorporate any of the MX or MAX described with respect to FIGs. 1 and 2, and in any of the configurations described with respect to FIGs. 4-8. The cross-sectional side view of FIG. 7B is the view in the y-z plane of the example coordinate system x-y-z shown in FIG. 7A, with the cross-section of FIG. 7B taken across the fin 722 (e.g., along the plane shown in FIG. 7A as a plane AA').

As shown in FIGS. 7A-7B, the fin 722 may extend away from the support structure 402 and may be substantially perpendicular to the support structure 402. The fin 722 may include one or more semiconductor materials, e.g. a stack of semiconductor materials, so that the upper-most portion of the fin (namely, the portion of the fin 722 enclosed by the gate electrode 404 and gate dielectric 406) may serve as the channel region of the FinFET 700. Therefore, the upper-most portion of the fin 722 may be formed of the channel material 408 as described above.

The subfin of the fin 722 may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth. For some example N-type transistor embodiments, the subfin portion of the fin 722 may be a III-V material having a band offset (e.g., conduction band offset for N-type devices) from the channel portion. Example materials, include, but are not limited to, GaAs, GaSb, GaAsSb, GaP, InAIAs, GaAsSb, AlAs, AIP, AlSb, and AIGaAs. In some N-type transistor embodiments of the FinFET 900 where the channel portion of the fin 722 (e.g., the channel portion) is InGaAs, the subfin may be GaAs, and at least a portion of the subfin may also be doped with impurities (e.g., P-type) to a greater impurity level than the channel portion. In an alternate heterojunction embodiment, the subfin and the channel portion of the fin 722 are each, or include, group IV semiconductors (e.g., Si, Ge, SiGe). The subfin of the fin 722 may be a first elemental semiconductor (e.g., Si or Ge) or a first SiGe alloy (e.g., having a wide bandgap).

As further shown in FIGS. 7A-7B, the STI material 720 may enclose portions of the sides of the fin 722. A portion of the fin 722 enclosed by the STI 720 forms a subfin. In various embodiments, the STI material 720 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 720 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

The gate stack (i.e., the gate dielectric 406 and gate electrode 404) may wrap around the upper portion of the fin 722 (the portion above the STI 720), as shown in FIGS. 7A-7B, with a channel portion of the fin 722 corresponding to the portion of the fin 722 wrapped by the gate stack as shown in FIGS. 7A-7B. In particular, the gate dielectric 406 (if used) may wrap around the upper-most portion of the fin 722, and the gate electrode 404 may wrap around the gate dielectric 406. The interface between the channel portion and the subfin portion of the fin 722 is located proximate to where the gate electrode 404 ends.

In some embodiments, the FinFET 700 may have a gate length, GL, (i.e. a distance between the first S/D region 710a and the second S/D region 710b), a dimension measured along the fin 722 in the direction of the x-axis of the example reference coordinate system x-y-z shown in FIGS. 7A-7B, which may, in some embodiments, be between about 5 and 40 nanometers, including all values and ranges therein (e.g. between about 22 and 35 nanometers, or between about 20 and 30 nanometers). The fin 722 may have a thickness, a dimension measured in the direction of the y-axis of the reference coordinate system x-y-z shown in FIGS. 7A-7B, that may, in some embodiments, be between about 5 and 30 nanometers, including all values and ranges therein (e.g. between about 7 and 20 nanometers, or between about 10 and 15 nanometers). The fin 722 may have a height, a dimension measured in the direction of the z-axis of the reference coordinate system x-y-z shown in FIGS. 7A-7B, which may, in some embodiments, be between about 30 and 350 nanometers, including all values and ranges therein (e.g. between about 30 and 200 nanometers, between about 75 and 250 nanometers, or between about 150 and 300 nanometers).

Although the fin 722 illustrated in FIGS. 7A-7B is shown as having a rectangular cross-section in a y-z plane of the reference coordinate system shown, the fin 722 may instead have a cross-section that is rounded or sloped at the "top" of the fin 722, and the gate stack may conform to this rounded or sloped fin 722. In use, the FinFET 700 may form conducting channels on three "sides" of the channel portion of the fin 722, potentially improving performance relative to single-gate transistors (which may form conducting channels on one "side" of a channel material or substrate) and double-gate transistors (which may form conducting channels on two "sides" of a channel material or substrate).

The S/D contacts 712a and 712b are electrically connected to the S/D regions 710a and 710b and extend in the same vertical direction with respect to the fin 722. In another example, one of the S/D contacts (e.g., the first S/D contact 712a) may be electrically connected to the first S/D region 710a and extend from the first S/D region 710a towards the support structure 402, thus forming a back-side S/D contact for the FinFET 700. In still another implementation, both the first S/D contact 712a and the second S/D contact 712b extend from the first and second S/D region 710a and 710b towards the support structure, thus forming two back-side S/D contacts for the FinFET 700.

### Example IC device with MX or MAX lined interconnects

FIG. 8 is a cross-sectional view of an example transistor with interconnects coupled to the transistor, where the interconnects may include an MX or MAX material, according to some embodiments of the present disclosure. FIG. 8 includes the transistor 500 described with respect to FIG. 5. The transistor 500 is coupled to a pair of S/D contacts 512a and 512b and a gate via 822. The gate via 822 is coupled to a first interconnect portion 826, the first S/D contact 512a is coupled to a second interconnect portion 824, and the second S/D contact 512b is coupled to a third interconnect portion 828.

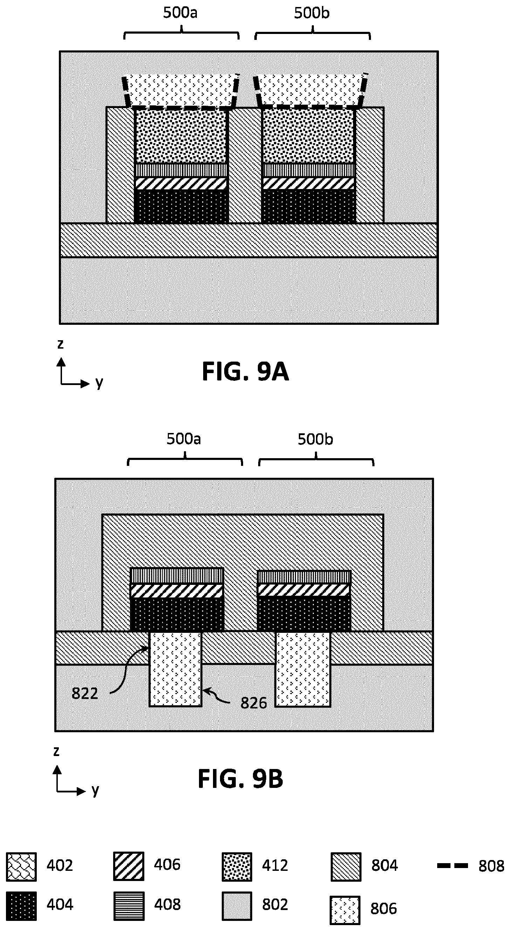

FIG. 8 illustrates two planes AA' and BB' through portions of the transistor 500 and surrounding interconnect material 806. Plane AA' illustrates a plane through the first S/D contact 512a, and plane BB' illustrates a plane through the gate via 822. FIG. 9A is cross-sectional view along the plane AA', and FIG. 9B is cross-sectional view along the plane BB'. FIGs. 9A and 9B each illustrate two neighboring transistors, e.g., the transistor 500a corresponds to the transistor 500 illustrated in FIG. 8, and an adjacent transistor 500b is located further into the page in the orientation shown in FIG. 8.

ILD material 802 is formed over the support structure 402. The ILD material 802 may be any suitable insulator material, such as a high-k dielectric or a low-k dielectric material, as described above. The ILD material 802 may be deposited in multiple layers, e.g., a first layer deposited above the support structure 402, and a second layer deposited over and around the transistor 500 and over another insulator layer 804, e.g., an etch stop layer. While a single ILD material 802 represented by a single pattern is shown in FIG. 8, in other embodiments, different types of ILD materials are used at different portions of the device.

Electrical signals are routed to the transistor 500 via interconnect 106. The interconnect 106 is formed into various interconnect structures that are typically arranged in multiple layers under and/or over electronic devices. In FIG. 8, a first interconnect layer 806a is disposed over the support structure 402 and under the transistor 500, and a second interconnect layer 806b is disposed over the transistor 500. Electrically conductive features of the electronic devices (e.g., the gate electrode 504 and the S/D contacts 512) are electrically coupled with interconnect structures of the interconnect layers 806a and 806b.

The interconnect structures may be arranged within the interconnect layers 806a and 806b and/or other interconnect layers not specifically shown in FIG. 8 to route electrical signals between different electrical devices according to a wide variety of designs. For example, additional interconnect structures may be coupled to additional circuit elements in an IC device, e.g., additional transistors, capacitors, or other devices.

The interconnect 806 is formed into trench structures, also referred to as "lines", and via structures, also referred to as "holes". The trench structures are arranged to route electrical signals in a direction of a plane that is substantially parallel with a surface of the support structure 402, i.e., the x-y plane in the coordinate system shown in FIG. 8. For example, some trench structures route electrical signals in a direction in and out of the page (the y-direction) from the perspective of FIG. 8, and other trench structures route electrical signals in a direction left and right (i.e., in the x-direction) from the perspective of FIG. 8. For example, the interconnect structure 826 is a trench structure extending in the x-direction. A cross-section of the interconnect structure 826 is shown in FIG. 9. The via structures are arranged to route electrical signals in a direction of a plane that is substantially perpendicular to the surface of the support structure 402, i.e., in the z-direction in the coordinate system shown in FIG. 8. For example, the interconnect structure 822 is a via, also referred to as a gate via. In some embodiments, the via structures may electrically couple trench structures of different interconnect layers together. For example, the trench interconnect structure 824 is coupled to a via 830 that couples the trench interconnect structure 824 in the second interconnect layer 806b to another trench structure 832 in the first interconnect layer 806a.

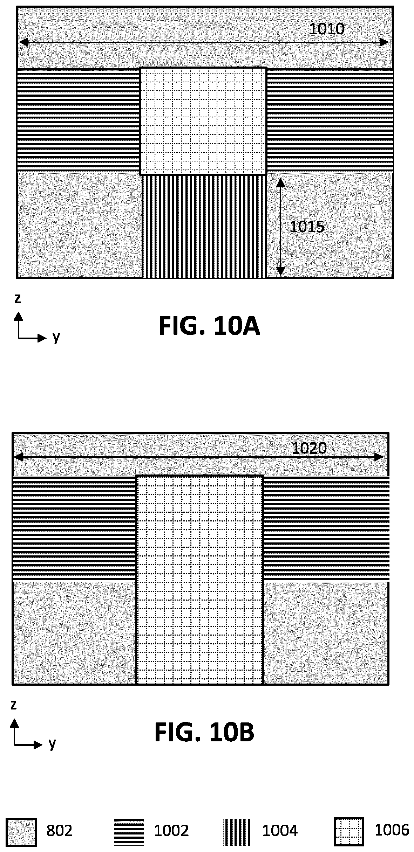

In some embodiments, the interconnect 806 is formed from a MX or MAX material, e.g., the materials described with respect to FIGs. 1 and 2. Embodiments in which the interconnect 806, or portions of the interconnect 806 (e.g., trenches and/or vias) are formed from MX or MAX materials are described further with respect to FIGs. 10A and 10B. In other embodiments, the interconnect 806 includes other electrically conductive materials, such as copper. More generally, the interconnect 806 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the interconnect 806 may include one or more electrically conductive alloys, oxides, or carbides of one or more metals. While a single interconnect material represented by a single pattern is shown in FIG. 8, in other embodiments, different interconnect materials are used at different portions of an IC device. For example, the via 822 coupling the gate electrode 404 to the trench 826 may be formed of a different conductive material from other portions of the interconnect 806.

In the illustration shown in FIG. 8, at least some portions of the interconnect 806 include a liner material 808. The liner material 808 forms an interconnect liner that lines an interconnect structure. In the example shown in FIG. 8, the liner material 808 forms a lining of the interconnect structures 824, 830, and 828. In some embodiments, the liner material 808 is or includes a MAX or MX material, e.g., the materials described with respect to FIGs. 1 and 2. MAX or MX liners 808 may be used in combination with any of the interconnect 806 materials discussed above, e.g., metals or metal alloys.

The liner material 808 may have a thickness of one or a few layers (e.g., a FL-MXene), or more layers (e.g., a ML-MXene). For example, the liner material 808 may have a thickness of less than 5 nanometers, or less than 2 nanometers. In some embodiments, the liner material 808 may include multiple layered MAX and/or MX materials. The layers may be oriented parallel to the support structure (e.g., along the bottom of the trench 832), perpendicular to the support structure (e.g., along the sides of the via 830), or in another orientation. In some embodiments, the orientation of the liner material 808 may depend on the orientation of the interconnect 806 and/or the primary direction of current flow through the interconnect 806. In some embodiments, a liner material 808 is included in certain portions of interconnect 806, e.g., along trenches, but not along vias, or vice versa.

As one example, after the transistor 500 is formed, portions of the second ILD layer are patterned to form the regions where the interconnect structures 130, 124, and 128 are formed. As used herein, "patterning" may refer to forming a pattern in one or more materials using any suitable techniques (e.g., applying a resist, patterning the resist using lithography, and then etching the one or more material using dry etching, wet etching, or any appropriate technique). The liner material 808 may be deposited in the patterned regions, and the interconnect 806 is deposited over the liner material 808 to form the interconnect structures 130, 124, and 128.

In the example shown in FIG. 8, a conformal deposition process, such as atomic layer deposition (ALD) or chemical vapor deposition (CVD), may be used to deposit the liner material 808. Conformal deposition generally refers to deposition of a certain coating on any exposed surface of a given structure. A conformal coating may, therefore, be understood as a coating that is applied to exposed surfaces of a given structure, and not, for example, just to the horizontal surfaces. In other embodiments, a non-conformal deposition process, also referred to as a directional deposition process, is used to deposit the liner material 808. Directional deposition processes include physical vapor deposition (PVD), e.g., sputtering. In such embodiments, the liner material 808 may not be present on vertical surfaces of the interconnect 806 (e.g., along the side walls of the via 830). In other embodiments, the liner material 808 is formed using a subtractive process, as described with respect to FIG. 11.

The liner material 808, or alternative liner materials, may be formed around other portions of the interconnect 806 than shown in FIG. 8. For example, the liner material 808 may be deposited along the tops of the interconnect structures 124 and 128. As another example, the liner material 808 may be formed around the first interconnect layer 806a, e.g., deposited below and/or above the interconnect structure 826. Liner materials around other portions of the interconnect 806 may be formed from different materials (e.g., tantalum and/or tantalum nitride) than the liner material 808 shown in FIG. 8.

An insulator 804 is formed over the first interconnect layer 806a and electrically separates the transistor 500 (in particular, the gate electrode 404) from the first interconnect layer 806a. The insulator 804 may include any of the insulating materials described with respect to the ILD 802 or other insulators, e.g., silicon oxide, carbon-doped silicon oxide, silicon carbide, silicon nitride, aluminum oxide, and/or silicon oxynitride. In some embodiments, the insulator 804 is or includes an etch-stop material; the etch-stop material may include, e.g., silicon nitride. As shown in FIG. 8, portions of interconnect 806 (e.g., the via 830) extend through the insulator 804 to form electrical connections between different layer of the interconnect (e.g., between the first interconnect layer 806a and the second interconnect layer 806b).

While the transistor 500 depicted in FIG. 1 has a back-side gate and front-side S/D contacts, in other embodiments, the lined interconnects described herein may be used in arrangements with different transistor architectures, e.g., the gate may be on the front-side, or one or both of the S/D regions and S/D contacts may be on the back-side, as described with respect to FIGs. 4 and 5. In other embodiments, the transistor 500 may have a non-planar architecture, such as a FinFET, as shown in FIG. 7. In some embodiments, the transistor 500 is a nanoribbon-based transistor (or, simply, a nanoribbon transistor, e.g., as described with respect to FIG. 3.

### Example MAX/MX interconnects

FIG. 10A and 10B are two example zoomed-in cross-sectional views of interconnect regions that include MX or MAX materials, according to some embodiments of the present disclosure. FIGs. 10A and 10B provide zoomed-in views of the region 850 illustrated in FIG. 8. In these examples, some of the interconnect 806 is formed from a MAX or MX material.

In FIG. 10A, the interconnect structure 824, also referred to as the trench 824, is formed of a first MAX or MX material 1002, and the interconnect structure 830, also referred to as the via 830, is formed of a second MAX or MX material 1004. The first material 1002 and second material 1004 may include the same materials (e.g., the same transition metal M and, for a MAX material, the same A group element A) or different materials (e.g., different transition metals M and/or different group A elements). In this example, the layer structures of the first material 1002 and 1004 are oriented differently, as indicated by the patterns used to represent the first material 1002 and the second material 1004. In particular, layers of the first material 1002 are arranged substantially parallel to the support structure 402 (shown in FIG. 8), in the x and y directions, so that current can flow along the trench 824, e.g., in the direction indicated by the arrow 1010. Layers of the second material 1004 are arranged substantially perpendicular to the support structure 402, in the x and z directions, providing high conductivity along the via 830, e.g., in the direction indicated by the arrow 1015. This orientation provides optimal current flow up and/or down the via 830 and along the trenches 824.

An interface material 1006 may be included at the interface between the trench 824 and the via 830. The interface material 1006 may be a material in which the conductivity is not directionally-dependent or is less directionally-dependent than the materials 1002 and 1004. For example, the interface material 1006 may be copper or another metal, or a metal alloy. The interface material 1006 improves current flow between the differently oriented MAX or MX layers in the first material 1002 and the second material 1004.

FIG. 10B shows another example interconnect configuration in which trench interconnects, e.g., the trench structure 824, is formed of the first MAX or MX material 1002, and the via 830 is formed of the interface material 1006. As in FIG. 10A, the layers of the first material 1002 are arranged substantially parallel to the support structure, in the x and y directions, providing high conductivity along the trench 824, i.e., in the direction indicated by the arrow 1020. The interface material 1006 provides via interfaces between trench structures and/or other conductive structures, such as S/D contacts and gate electrodes, formed in different layers of an IC device (e.g., as illustrated in FIG. 8). In this embodiment, the interface material 1006 extends into the trench structure 824, but in other embodiments, the interface material 1006 may stop below the trench structure 824, or extend partway through the trench structure 824 in the z-direction. In another embodiment, vias (e.g., the via 830), but not trenches (e.g., not the trench 824), may be formed from a MAX or MX material, while trenches are formed from a different material, such as copper or another metal.

### Example Method for Forming IC Device with Interconnect Liner

FIG. 11 is a flowchart illustrating a method 1100 for forming a layered MX or MAX conductive material in an IC device, according to some embodiments of the present disclosure. The method begins with depositing 1102 one or more layers of a MX or MAX material. For example, the MX or MAX material may be grown as one or more layers or sheets over a support structure and/or other layers of an IC device. Alternatively, one or more layers of the MX or MAX material may be grown on a separate substrate and layer-transferred onto another structure, e.g., over a support structure and/or other layers of an IC device. If a MX material is used, the A group material may be selectively etched, as described with respect to FIG. 2.

The method 1100 proceeds with patterning 1104 a resist over the MX or MAX material. A resist layer may be deposited over the MX or MAX layers, e.g., by spin-coating. The resist material may be patterned based on a design for a particular conductive region or set of conductive regions of an IC device to be formed from the MX or MAX material, e.g., to form contacts, to form a layer (e.g., a barrier layer or cap layer) over or under contacts, to form trenches of an interconnect layer, or to form a liner layer for an interconnect layer. The resist may be patterned using any known technique, e.g., by lithographically patterning the resist, and etching portions of the resist.

The method 1100 proceeds with etching 1106 portions of the MX or MAX layers, e.g., the portions exposed by the patterned resist. Etching the MX or MAX layers subtractive forms a particular conductive region or set of conductive regions of an IC device, e.g., contacts, a layer (e.g., a barrier layer or cap layer) over or under contacts, trenches of an interconnect layer, or a liner layer for an interconnect layer.

The method 1100 proceeds with depositing 1108 an insulator over the etched MX or MAX layers. An insulator, such as an ILD, may be deposited over the MX or MAX material, and in particular, into the etched regions. This results in a layer with conductive structures formed by the MX or MAX material with insulator between the conductive structures.

### Example devices

The conductive regions formed from MX or MAX materials disclosed herein may be included in any suitable electronic device. FIGS. 12-15 illustrate various examples of apparatuses that may include the interconnects with barrier material liners disclosed herein.

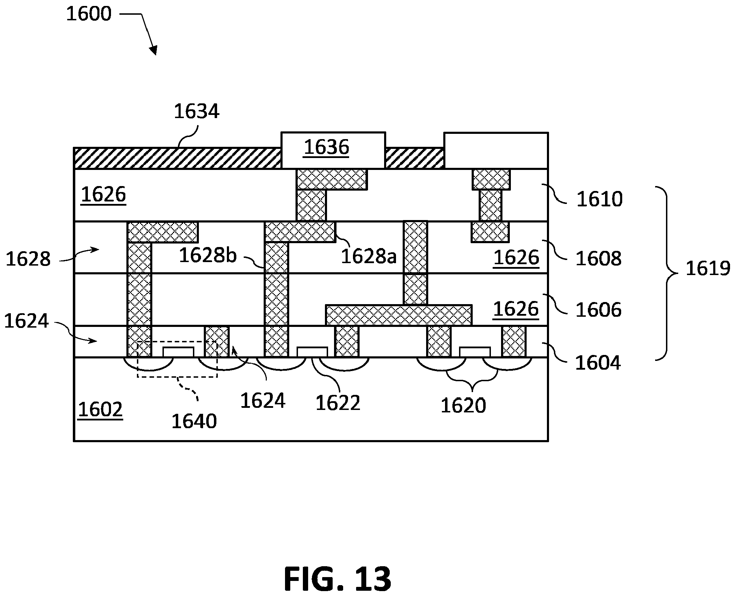

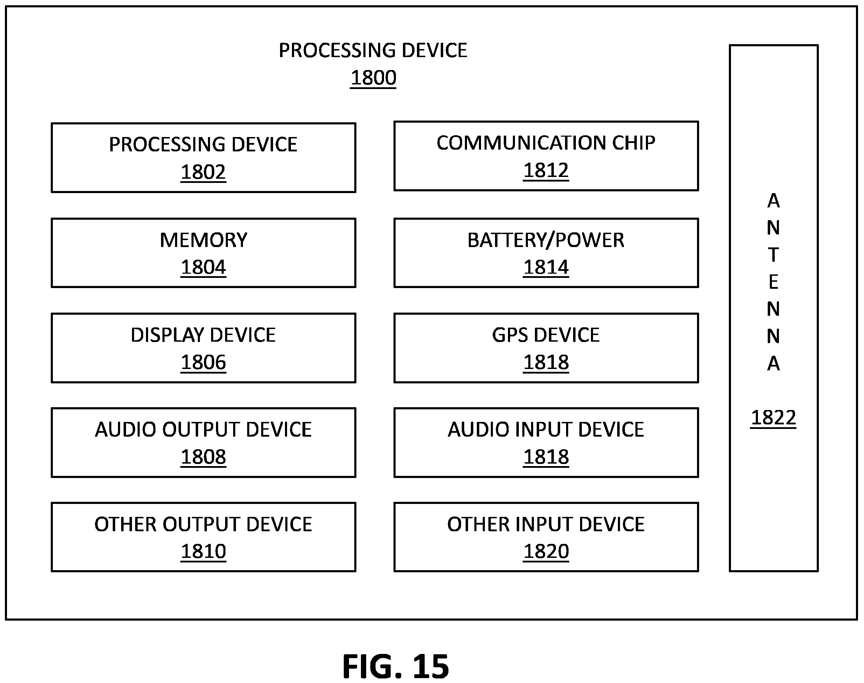

FIG. 12A and 12B are top views of a wafer and dies that include one or more IC structures with one or more conductive regions formed from MX or MAX materials in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 3-10, or any further embodiments of the IC structures described herein). After the fabrication of the semiconductor product is complete (e.g., after manufacture of one or more IC structures with one or more conductive regions formed from MX or MAX materials as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more IC structures with conductive regions formed from MX or MAX materials as disclosed herein may take the form of the wafer 1500 (e.g., not singulated) or the form of the die 1502 (e.g., singulated). The die 1502 may include one or more transistors (e.g., one or more of the transistors 1640 of FIG. 13, discussed below) and/or supporting circuitry to route electrical signals to the transistors, as well as any other IC components (e.g., one or more IC structures with conductive regions formed from MX or MAX materials). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 15) or other logic that is configured to store information in the memory devices or execute instructions stored in the memory array.

FIG. 13 is a cross-sectional side view of an IC device 1600 that may include one or more IC structures with one or more conductive regions formed from MX or MAX materials in accordance with any of the embodiments disclosed herein. The IC device 1600 may be formed on a substrate 1602 (e.g., the wafer 1500 of FIG. 12A) and may be included in a die (e.g., the die 1502 of FIG. 12B). The substrate 1602 may be any substrate as described herein. The substrate 1602 may be part of a singulated die (e.g., the dies 1502 of FIG. 12B) or a wafer (e.g., the wafer 1500 of FIG. 12A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 13 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

Although not specifically shown in FIG. 13, the IC device 1600 may include one or more conductive regions formed from MX or MAX materials at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 13 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 13). Although a particular number of interconnect layers 1606-1610 is depicted in FIG. 13, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 13. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 13. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

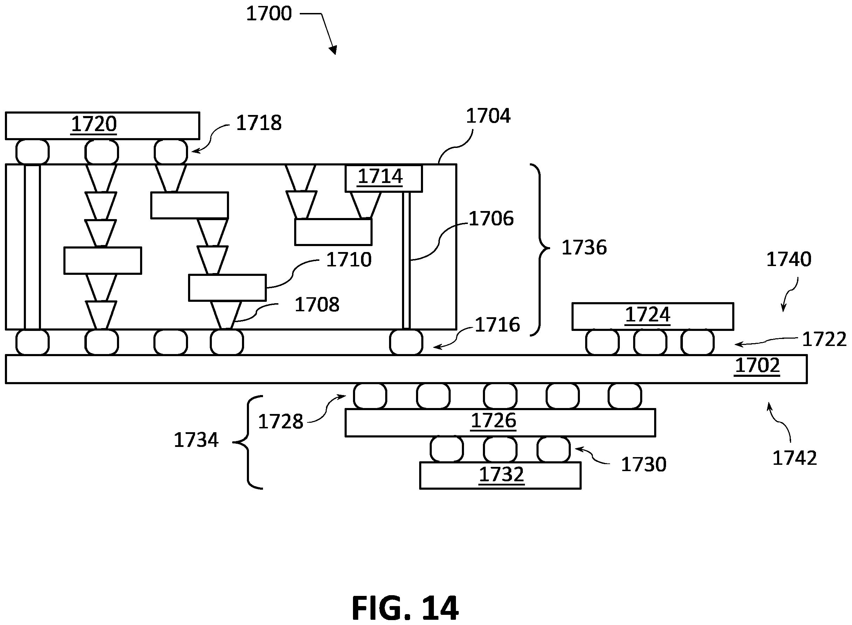

FIG. 14 is a cross-sectional side view of an IC device assembly 1700 that may include components having or being associated with (e.g., being electrically connected by means of) one or more IC structures with conductive regions formed from MX or MAX materials in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the conductive regions formed from MX or MAX materials, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 14 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 14), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 14, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 12B), an IC device (e.g., the IC device 1600 of FIG. 13), or any other suitable component. In some embodiments, the IC package 1720 may include conductive regions formed from MX or MAX materials, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 14, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The interposer 1704 may further include conductive regions formed from MX or MAX materials, as described herein. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 14 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 15 is a block diagram of an example computing device 1800 that may include one or more components including one or more IC structures with one or more conductive regions formed from MX or MAX materials in accordance with any of the embodiments disclosed herein. For example, any suitable ones of the components of the computing device 1800 may include a die (e.g., the die 1502 of FIG. 12B) having conductive regions formed from MX or MAX materials as described herein. Any one or more of the components of the computing device 1800 may include, or be included in, an IC device 1600 (FIG. 13). Any one or more of the components of the computing device 1800 may include, or be included in, an IC device assembly 1700 (FIG. 14).

A number of components are illustrated in FIG. 15 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 15, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

The following paragraphs provide various examples of the embodiments disclosed herein.

Example 1 provides an IC device including a transistor including a gate and a channel; and a S/D contact coupled to the channel, the S/D contact including a plurality of layers of material, a layer of the material including a transition metal and at least one of carbon and nitrogen.

Example 2 provides the IC device of example 1, where the transition metal in the material includes a material in group 3 through 6 of the periodic table.

Example 3 provides the IC device of example 1 or 2, further including a second layer formed between two of the plurality of layers, the second layer including a main group element.

Example 4 provides the IC device of example 3, where the main group element is in one of groups 13 and 14 of the periodic table.

Example 5 provides the IC device of any of the preceding examples, where the channel includes a transition metal dichalcogenide (TMD).

Example 6 provides the IC device of any of the preceding examples, where the channel includes at least one nanoribbon formed over a support structure, where the nanoribbon extends in a direction substantially parallel to the support structure.

Example 7 provides the IC device of example 6, where a layer of the material extends in a direction substantially parallel to the nanoribbon.

Example 8 provides the IC device of example 6 or 7, where the nanoribbon is a first nanoribbon, the channel further including a second nanoribbon stacked over the first nanoribbon, and at least one layer of the material is between the first nanoribbon and the second nanoribbon.

Example 9 provides the IC device of any of examples 1 through 5, where the channel is formed over a support structure, and the S/D contact is formed between the support structure and the channel.

Example 10 provides the IC device of example 9, where the transistor is over a support structure, and the channel extends in one direction substantially parallel to the support structure, and in a second direction substantially perpendicular to the support structure, the channel forming a fin.

Example 11 provides the IC device of any of examples 1 through 5, where the S/D contact includes a first region and a second region, the first region between the channel and the second region, where the first region includes the plurality of layers of the material, and the second region includes a metal.

Example 12 provides the IC device of example 11, where the first region has a thickness of less than 2 nanometers.

Example 13 provides the IC device of any of examples 1 through 5, where the S/D contact includes a first region and a second region, the first region between the channel and the second region, where the first region includes a metal, and the second region includes the plurality of layers of the material.

Example 14 provides the IC device of example 13, where the second region has a thickness of less than 2 nanometers.

Example 15 provides an IC device including a transistor including a gate and a channel; a S/D contact coupled to the channel; and an interconnect region coupled to the S/D contact, the interconnect region including a plurality of layers of material, a layer of the material including a transition metal and at least one of carbon and nitrogen.

Example 16 provides the IC device of example 15, where the transition metal in the material includes a material in group 3 through 6 of the periodic table.

Example 17 provides the IC device example 15 or 16, further including a second layer formed between two of the plurality of layers, the second layer including a main group element.

Example 18 provides the IC device of example 17, where the main group element is in one of groups 13 and 14 of the periodic table.

Example 19 provides the IC device of any of examples 15 through 18, where the interconnect region extends in a direction substantially parallel to a support structure, and the plurality of layers are arranged in the direction substantially parallel to the support structure.

Example 20 provides the IC device of any of examples 15 through 18, where the interconnect region extends in a direction substantially perpendicular to a support structure, and the plurality of layers are arranged in the direction substantially perpendicular to the support structure.

Example 21 provides the IC device of example 20, where the interconnect region is a first interconnect region, the IC device further including a second interconnect region, where the second interconnect region extends in a direction substantially parallel to the support structure, and the plurality of layers are arranged in the direction substantially parallel to the support structure.

Example 22 provides the IC device of example 21, further including a third interconnect region including a metal, where the first interconnect region and the second interconnect region are coupled to the third interconnect region.

Example 23 provides the IC device of any of examples 15 through 20, further including a metal interconnect coupled to the interconnect region, where the interconnect region forms a liner between the metal interconnect and the S/D contact.

Example 24 provides the IC device of example 23, where the interconnect region has a thickness of less than 2 nanometers.

Example 25 provides a method for forming a conductive layer in an IC device, the method including forming a conductive film over a support structure, the conductive film including a plurality of layers of material over a support structure, a layer of the material including a transition metal and at least one of carbon and nitrogen; etching a portion of the conductive film; and depositing an insulator material into the etched portion.

Example 26. The method of example 25, further including depositing a resist material over the conductive film; and patterning the resist material, where at least a second portion of the conductive film under the resist material is not etched.

Example 27 provides the method of example 25 or 26, where forming the conductive film includes depositing a layer of a MAX material, the MAX material including the transition metal, the at least one of carbon and nitrogen, and an A-group material; and removing the A-group material.

Example 28 provides the method of any of examples 25-27, where the transition metal in the material includes a material in group 3 through 6 of the periodic table.

Example 29 provides the method of any of examples 25-28, where the conductive film further includes a second layer formed between two of the plurality of layers, the second layer including a main group element.

Example 30 provides the IC method of example 29, where the main group element is in one of groups 13 and 14 of the periodic table.

Example 31 provides an IC package that includes an IC die, including one or more of the IC devices according to any one of the preceding examples. The IC package may also include a further component, coupled to the IC die.

Example 32 provides the IC package according to example 31, where the further component is one of a package substrate, a flexible substrate, or an interposer.

Example 33 provides the IC package according to examples 31 or 32, where the further component is coupled to the IC die via one or more first level interconnects.

Example 34 provides the IC package according to example 33, where the one or more first level interconnects include one or more solder bumps, solder posts, or bond wires.

Example 35 provides a computing device that includes a circuit board; and an IC die coupled to the circuit board, where the IC die includes one or more of the memory/IC devices according to any one of the preceding examples (e.g., memory/IC devices according to any one of examples 1-30), and/or the IC die is included in the IC package according to any one of the preceding examples (e.g., the IC package according to any one of examples 31-34).

Example 36 provides the computing device according to example 35, where the computing device is a wearable computing device (e.g., a smart watch) or hand-held computing device (e.g., a mobile phone).

Example 37 provides the computing device according to examples 35 or 36, where the computing device is a server processor.

Example 38 provides the computing device according to examples 35 or 36, where the computing device is a motherboard.

Example 39 provides the computing device according to any one of examples 35-36, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a transistor comprising a gate and a channel; and
a source or drain (S/D) contact coupled to the channel, the S/D contact comprising a plurality of layers of material, a layer of the material comprising a transition metal and at least one of carbon and nitrogen.

2. The IC device of claim 1, wherein the transition metal in the material comprises a material in group 3 through 6 of the periodic table.

3. The IC device of any one of claims 1-2, further comprising a second layer formed between two of the plurality of layers, the second layer comprising a main group element.

4. The IC device of claim 3, wherein the main group element is in one of groups 13 and 14 of the periodic table.

5. The IC device of any one of claims 1-4, wherein the channel comprises a transition metal dichalcogenide (TMD).

6. The IC device of any one of claims 1-5, wherein the channel comprises at least one nanoribbon formed over a support structure, wherein the nanoribbon extends in a direction substantially parallel to the support structure.

7. The IC device of claim 6, wherein a layer of the material extends in a direction substantially parallel to the nanoribbon.

8. The IC device of any one of claims 6-7, wherein the nanoribbon is a first nanoribbon, the channel further comprising a second nanoribbon stacked over the first nanoribbon, and at least one layer of the material is between the first nanoribbon and the second nanoribbon.

9. The IC device of any one of claims 1-5, wherein the channel is formed over a support structure, and the S/D contact is formed between the support structure and the channel.

10. The IC device of claim 9, wherein the transistor is over a support structure, and the channel extends in one direction substantially parallel to the support structure, and in a second direction substantially perpendicular to the support structure, the channel forming a fin.

11. The IC device of any one of claims 1-5, wherein the S/D contact comprises a first region and a second region, the first region between the channel and the second region, wherein the first region comprises the plurality of layers of the material, and the second region comprises a metal.

12. The IC device of claim 11, wherein the first region has a thickness of less than 2 nanometers.

13. The IC device of any one of claims 1-5, wherein the S/D contact comprises a first region and a second region, the first region between the channel and the second region, wherein the first region comprises a metal, and the second region comprises the plurality of layers of the material.

14. A method for forming a conductive layer in an integrated circuit (IC) device, the method comprising:
forming a conductive film over a support structure, the conductive film comprising a plurality of layers of material over a support structure, a layer of the material comprising a transition metal and at least one of carbon and nitrogen;
etching a portion of the conductive film; and
depositing an insulator material into the etched portion.

15. The method of claim 14, further comprising:
depositing a resist material over the conductive film; and
patterning the resist material, wherein at least a second portion of the conductive film under the resist material is not etched.
